## Europäisches Patentamt

## European Patent Office

## Office européen des brevets

(11) Veröffentlichungsnummer: **0 176 981**
**B1**

(12) # EUROPÄISCHE PATENTSCHRIFT

(45) Veröffentlichungstag der Patentschrift:
06.09.89

(51) Int. Cl.⁴: **H03M 1/74**

(21) Anmeldenummer: **85112291.1**

(22) Anmeldetag: **27.09.85**

(54) **D/A-Wandler.**

(30) Priorität: **28.09.84 DE 3435715**

(43) Veröffentlichungstag der Anmeldung:
**09.04.86 Patentblatt 86/15**

(45) Bekanntmachung des Hinweises auf die Patenterteilung:
**06.09.89 Patentblatt 89/36**

(84) Benannte Vertragsstaaten:
**AT BE CH DE FR GB IT LI NL SE**

(56) Entgegenhaltungen:
**EP-A- 0 043 897**
**US-A- 4 016 555**

(73) Patentinhaber: **Siemens Aktiengesellschaft,
Wittelsbacherplatz 2, D-8000 München 2(DE)**

(72) Erfinder: **Irmer, Heimbert, Dipl.-Ing., Jagdfeldring 14,
D-8013 Haar(DE)**
Erfinder: **Mühlbauer, Otto, Ing. grad.,
Untersbergstrasse 82, D-8000 München 90(DE)**

ACTORUM AG

## Beschreibung

Die Erfindung betrifft einen D/A-Wandler gemäß dem Oberbegriff des Patentanspruches 1.

Ein derartiger D/A-Wandler ist aus der europäischen Patentanmeldung EP-A2-043 897 bekannt.

Bekanntlich arbeiten D/A-Wandler in der Weise, daß entsprechend dem digitalen, zu wandelnden Wert über Steuerleitungen gewichtete Quellen angesteuert werden, deren Ausgangssignale aufaddiert werden und den Analogwert bilden. Beim Umschalten von kritischen, an sich bekannten Wortkombinationen, beispielsweise von 01111 nach 10000, können jedoch Überspannungsspitzen, sogenannte Glitches, auftreten. Diese haben ihre Ursachen in den Laufzeitunterschieden gleichzeitig an- und abschaltender Quellen bzw. in der Asynchronität der Daten auf den Bitleitungen und in den unterschiedlichen Toleranzen der gewichteten Quellen.

Eine bekannte Maßnahme um derartige Überspannungsspitzen zu verhindern, ist die Benutzung von Einzelquellen, die über einen Thermometerdekoder angesteuert werden. Beim Thermometerdekoder werden neben der der Bitwertigkeit des Digitalwertes zugeordneten Dekodierleitung auch alle anderen niederwertigen Dekodierleitungen zur Ansteuerung der Einzelquellen aktiviert. Bedingt durch die stetige Zunahme der Anzahl der ausgewählten Dekodierleitungen wird mit wachsendem Binärwort nur jeweils eine Quelle hinzugeschaltet bzw. mit kleiner werdendem Binärwort jeweils nur eine Quelle abgeschaltet. Diese Wortkombinationen haben somit trotz Änderung aller Binärbits nur das Umschalten einer einzigen Quelle zur Folge. Umschaltspitzen aufgrund des Umschaltens von mehreren Quellen können nicht auftreten.

Ein derartiger einschrittiger D/A-Wandler ist in der Zeitschrift "Elektroniker" Nr. 5/1976, S. EL1 bis EL8 beschrieben. Diese Anordnung hat jedoch einen großen Flächenaufwand zur Folge, welcher durch den Dekoder, den Verdrahtungskanal und die hohe Anzahl von Einzelquellen bedingt ist. Zur Wandlung eines n-Bit breiten Digitalwortes sind nämlich ein $2^n$-stufiger Dekoder und $2^n$ Einzelquellen erforderlich. Das Fan-in in dieser $2^n$-Dekoderstufe begrenzt den Einsatzbereich zu hohen Frequenzen hin. Ein D/A-Wandler der eingangs genannten Art hat den Nachteil, daß mehrere ROMs in Reihenschaltung erforderlich sind, um die Zeileninformation zu dekodieren.

Der Erfindung lag daher die Aufgabe zugrunde, den Flächen- und Schaltungsaufwand für einen D/A-Wandler der oben genannten Art zu verringern.

Diese Aufgabe wird gemäß dem kennzeichnenden Teil des Anspruches 1 gelöst. Weiterbildungen der Erfindung ergeben sich aus den Unteransprüchen.

Die Erfindung beruht darauf, zwei Thermometer-Dekoder mit einer Quellenmatrix zusammenzuschalten. Anstelle eines m-aus-$2^n$-Dekoders werden vorteilhafterweise zwei m-aus-$2^{n/2}$-Dekoder mit jeweils $2^{n/2}$ Stufen eingesetzt. Im Kreuzungspunkt der Matrix kann durch die Zeilen- und Spalteninformation die Stufung eines m-aus-$2^n$-Dekoders nachgebildet werden.

Der Verdrahtungsaufwand wird durch ein zweidimmensionales Matrixfeld verringert. Dadurch werden die Kapazitäten in der Verdrahtung herabgesetzt, was einen Betrieb mit hohen Frequenzen ermöglicht. Das hat eine geringere Gatterlaufzeit und somit eine Verkürzung der Wandlungszeit zur Folge. Durch die Aufspaltung der Eingangsstufen wird eine Verringerung des Fan-in des Wandlers und eine Verringerung der Verlustleistung erreicht. Dies trifft insbesonders bei einer Realisierung in Einkanal MOS-Technologie zu, da die üblicherweise in m-aus-$2^n$-Dekodern verwendeten NAND-Funktionen mit mehr als zwei Eingängen nur schwer zu realisieren sind. Sie müssen durch Umformungen eines X-fach NAND-Gatters mit zusätzlichen, nicht minimierten Gattern realisiert werden.

Im folgenden wird die Erfindung anhand zweier Ausführungsbeispiele weiter beschrieben.

Fig. 1 zeigt schematisch einen erfindungsgemäßen D/A- Wandler,

Fig. 2 zeigt Einzelheiten des D/A-Wandlers nach Fig. 1,

Fig. 3 zeigt Einzelheiten eines weiteren D/A-Wandlers,

Fig. 4 zeigt tabellarisch Steuersignale für die Anordnungen gemäß Fig. 2 und 3,

Fig. 5, 6 zeigen jeweils schematisch Beispiele für kritische Schaltzustände der erfindungsgemäßen Anordnung und

Fig. 7 zeigt das Schaltbild eines Thermometerdekoders.

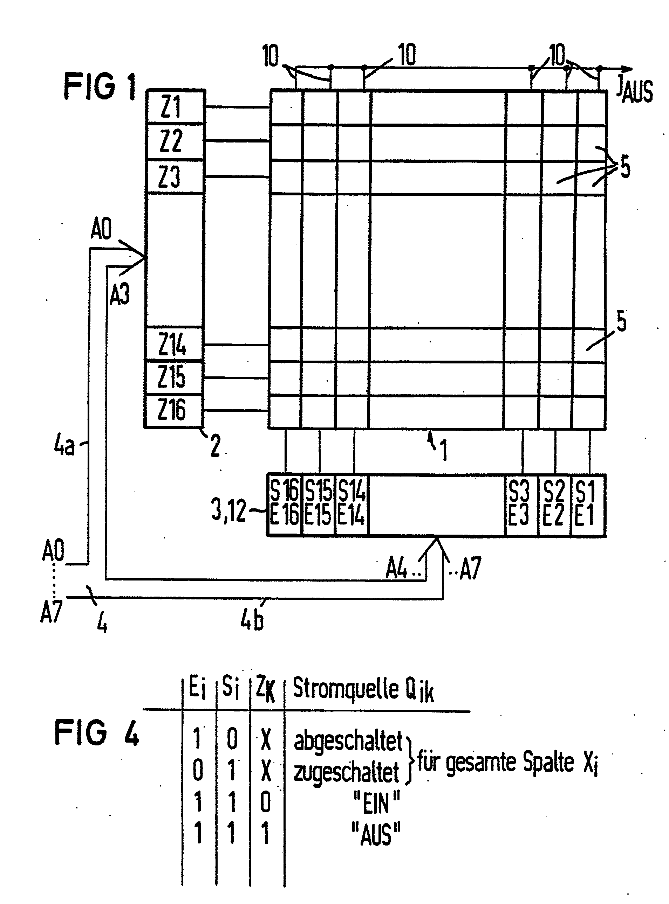

Gemäß Fig. 1 besteht der D/A-Wandler aus einem Quellenfeld in Matrixanordnung 1 , aus einem Zeilendekoder 2 und einer, einem Spaltendekoder 3 nachgeschalteten ersten Logikanordnung 12. In jedem Matrixpunkt 5 liegt eine Einzelquelle, beispielsweise eine Strom- oder Spannungsquelle, die durch Ansteuerung über die beiden Dekoder spaltenweise auf einem Strombus 10 zusammengeschaltet werden, wobei das aufsummierte Analogsignal $I_{AUS}$ auf einer alle Strombusse 10 zusammenfassenden Leitung abgreifbar ist.

Das zu wandelnde Digitalsignal $A_0$ bis $A_7$ wird den beiden Dekodern 2, 3 über n parallele Digitalleitungen 4 zugeführt. Der Zeilendekoder 2 ist den niederwertigen Bits $A_0$ bis $A_{(n/2)-1}$ zugeordnet, während der Spaltendekoder 3 die Gewichtung der höherwertigen Bits $A_{n/2}$ bis $A_n$ übernimmt. Den jeweils $2^{n/2}$ Stufen entsprechend sind zwei m aus $2^{n/2}$-Dekoder erforderlich. Die Matrix 1 umfaßt $2^{n/2}$ x $2^{n/2}$ Einzelquellen. Das in Fig. 1 wiedergegebene Beispiel ist für ein 8 Bit breites Datenwort $A_0$ bis $A_7$ und somit für eine 16 x 16 Einzelquellen umfassende Matrix 1 ausgelegt. Der Zeilen- und der Spaltendekoder 2, 3 sind als Thermometerdekoder ausgeführt.

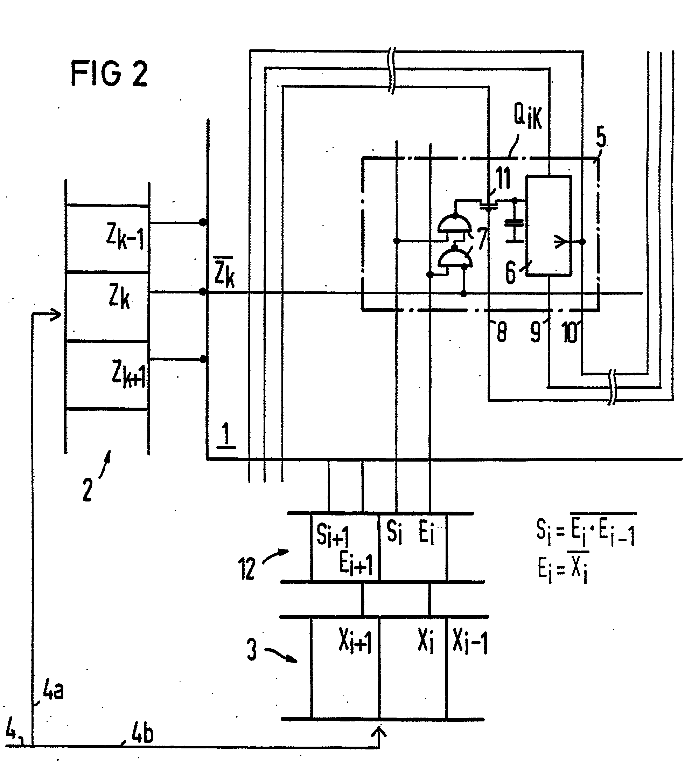

Fig. 2 zeigt beispielhaft, wie durch eine logische Verknüpfung benachbarter Auskodierleitungen eine zusätzliche Information $S_i$ am Ausgang des Spaltendekoders 3 ermittelt wird, welche diejenige Spalte $X_i$ bestimmt, in welcher entsprechend der Kodierung des Zeilendekoders 2 die Dekoderstufung aktuell ausgeführt wird. Diese Information wird dazu benützt, die Quellen 6 aller derjenigen Spalten, die niedrigeren Spaltenleitungen zugeordnet sind, vollständig aktiv und unabhängig vom Zustand des Zeilendekoders 2 zu halten, während die Quellen derjenigen Spalten , die höherwertiger sind, nicht aktiviert werden können.

In dem wiedergegebenen Beispiel umfassen der Zeilen- und Spaltendekoder 2, 3 k bzw. i Dekoderstufen (k, i = 1 bis 15). Das aktuell über die Zeile $Z_k$ und die Spalte $X_i$ angewöhlte Matrixelement 5 mit einer Einzelquelle 6 ist mit $Q_{ik}$ bezeichnet. Die Einzelquelle 6 liegt an einer Versorgungsleitung 9 und ausgangsseitig an einem Strombus 10. Ihr Steuereingang ist über eine Logikanordnung 7 mit der zugehörigen, mit invertiertem Signal beaufschlagten Zeilenleitung $\bar{Z}_k$, einer weiteren Spaltenleitung $E_i$ und der zusätzlichen Informationsleitung $S_i$ verbunden. Die Ansteuerung wird mittels eines über eine Taktleitung 8 gesteuerten Synchronisierschaltung 11, bestehend aus einem FET, synchronisiert, die zwischen der Logikanordnung 7 und der betreffenden Einzelquelle 6 liegt. Die Information des Zeilendekoders 2 und des Spaltendekoders 3 wird also mit der zusätzlichen Information im Matrixpunkt 5 zu einem Steuersignal für die Einzelquelle 6 logisch verknüpft. Die Taktleitung 8, die Versorgungsleitung 9 und der Strombus 10 sind für alle Quellen $Q_{ik}$ gemeinsam durchgeschleift. Im wiedergegebenen Beispiel ist die Schleife mäanderförmig ausgeführt, wobei nebeneinanderliegende Matrixspalten nacheinander durchlaufen werden.

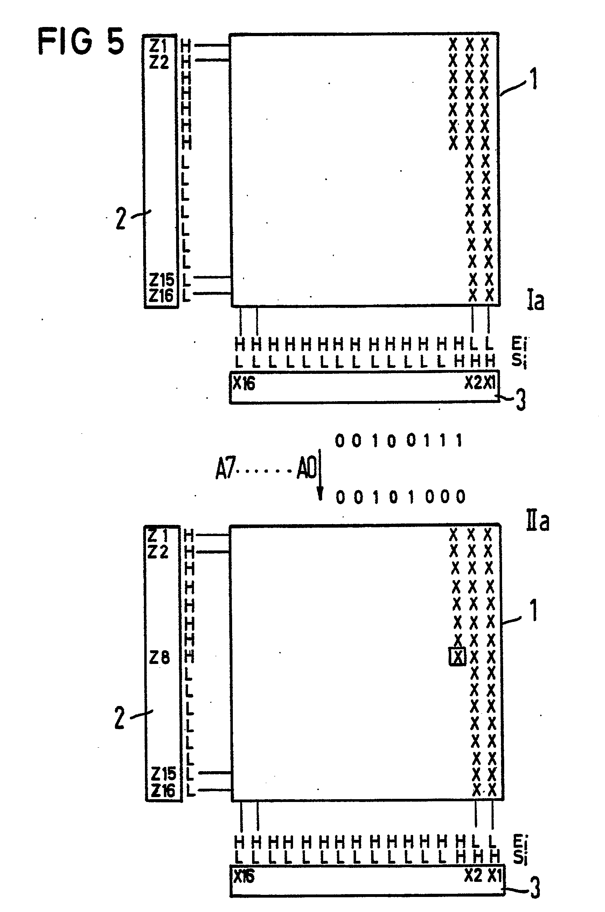

Aus der in Fig. 4 wiedergegebenen Tabelle ist die Funktion der Logikanordnung 7 entnehmbar. Sie zeigt, daß bei einem logisch-0-Zustand der zusätzlichen Informationsleitung $S_i$ und bei einem logisch-1-Zustand der weiteren Spaltenleitung $E_i$ unabhängig vom Zustand der zugehörigen Zeilenleitung $Z_k$ alle Einzelquellen 6 der betreffenden Spalte $X_i$ abgeschaltet sind. Im Fall einer logischen Null bzw. logischen Eins der zusätzlichen Informationsleitung $S_i$ bzw. Spaltenleitung $E_i$ sind unabhängig vom Signal auf der Zeilenleitung $Z_k$ alle Stromquellen der zugehörigen Spalte $X_i$ zugeschaltet. Liegen sowohl Informationsleitung $S_i$ als auch weitere Spaltenleitung $E_i$ auf logisch 1, so wird die Einzelquelle 6 des Quellenelements $Q_{ik}$ bei einer logischen Null auf der Zeilenleitung $Z_k$ ein- und bei einer logischen Eins ausgeschaltet, entsprechend dem Zeilendekoder Z.

Die Signale auf der zusätzlichen Informationsleitung $S_i$ und der weiteren Spaltenleitung $E_i$ werden in einer dem Spaltendekoder 3 nachgeschalteten logischen Anordnung 12 aus dem Signal der Spaltenleitung $X_i$ durch folgende log.Verknüpfung generiert:

$$E_i = \overline{X_i} \text{ und } S_i = \overline{E_i} \cdot E_{i-1},$$

wobei mit $S_i$ die Information auf der zusätzlichen Informationsleitung mit $\overline{X_i}$ bzw. $E_i$ die Information auf der Spalten- bzw. weiteren Spaltenleitung bezeichnet sind.

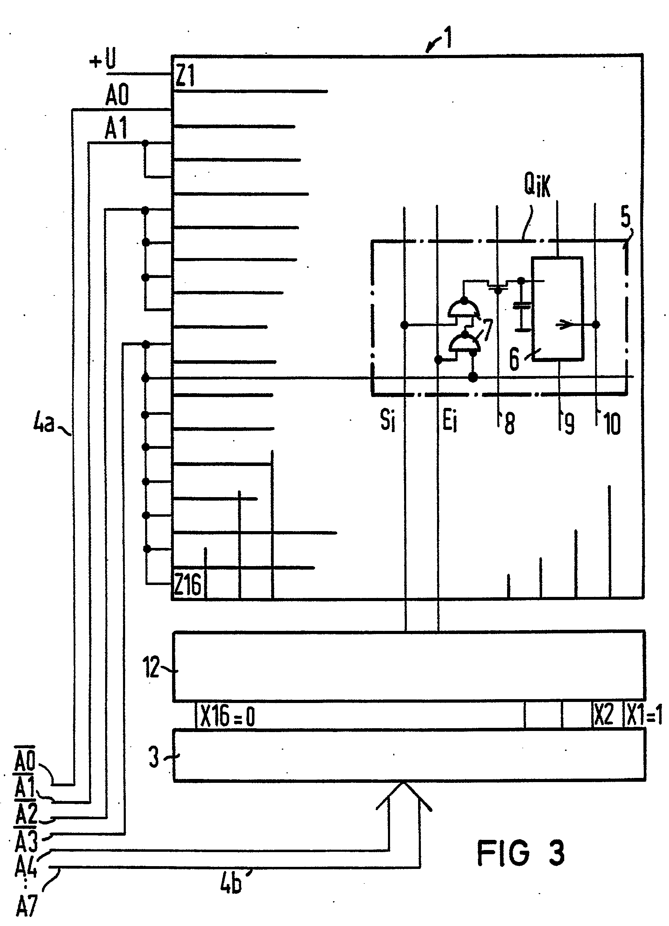

Fig. 3 zeigt ein Beispiel mit einer 16 x 16 Einzelquellen umfassenden Matrix 1, welche über eine Einzelgewichtung auf den negierten niederwertigen Bits $\bar{A}_0$ bis $\bar{A}_3$ (Zeilen $Z_1$ bis $Z_{16}$) und mittels Binärgewichtung auf den höherwertigen Bits A4 bis A7 (Spalten X1 bis X16) angesteuert ist. Bei der Einzelgewichtung wird die Ansteuerung der Zeilen $Z_1$ bis

$Z_{16}$ direkt aus dem die vier niederwertigen Bits umfassenden Teil des Binärwortes abgeleitet. Wie die Fig. zeigt, sind die entsprechenden Digitalleitungen 4a entsprechend der Wertigkeit ihrer Information gewichtet und mit jeweils n Zeilenleitungen $Z_k (n= 0$ bis 3) verbunden. Die Ausgestaltung und Funktion der Matrixelemente 5, des Spaltendekoders 3 und der logischen Anordnung 12 entsprechen dem in Fig. 2 beschriebenen Beispiel. Als definierte Ausgangsstellung ist die Information $x_{16} = 0$ und $x_1 = 1$.

Durch die Einsparung von Eingangsleitungen durch Zusammenfassung vom Matrixelementen 5 entsprechend der Gewichtung und des Zeilendekoders wird eine weitere Flächenersparnis bei gleichzeitig zufriedenstellender Unterdrückung der Überspannungsspitzen erreicht.

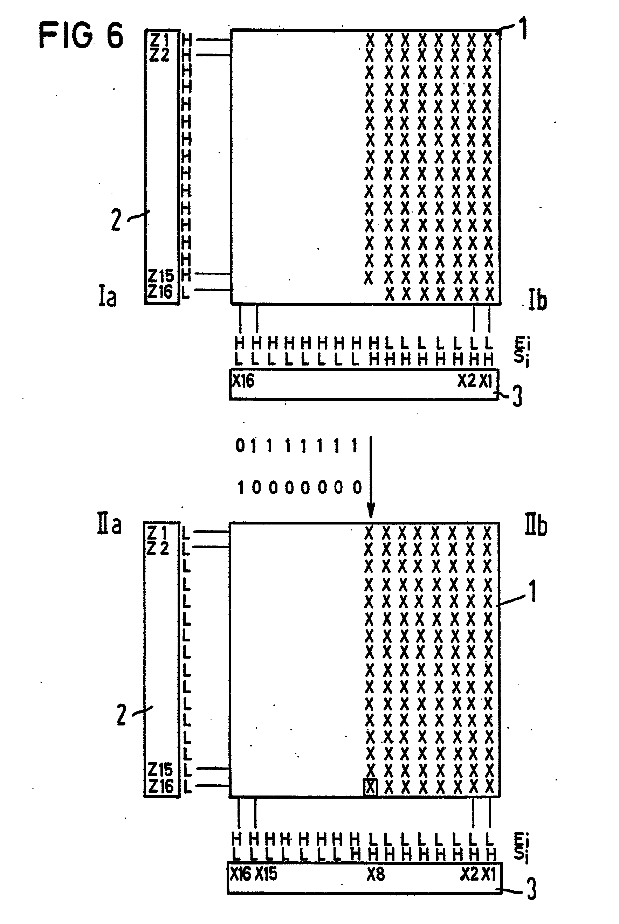

Die Fig. 5 und 6 zeigen schematisch jeweils Schaltzustände der Einzelquellen 6 beim Umschalten von kritischen Wortkombinationen. Eingeschaltete Einzelquellen sind dabei jeweils durch ein "X" gekennzeichnet. Im ersten Beispiel (Fig. 5) ist der Übergang von einem auf den Digitalleitungen A7 bis A0 anstehenden Digitalwort 00100111 zu einem Digitalwort 00101000 wiedergegeben. An den Ausgängen des Zeilendekoders 2 sind die zugehörigen logischen Zustände H bzw. L und am Spaltendekoder 3 die zu den Spaltenleitungen X1 bis X16 gehörenden Signale auf den weiten Spaltenleitungen $S_i$ und zusätzlichen Informationsleitungen $E_i$ angegeben. Beim Übergang vom ersten Zustand Ia zum zweiten Zustand IIa wird trotz der kritischen Wortkombination lediglich eine Einzelquelle in Zeile Z8 und Spalte X3 zugeschaltet.

In dem in Fig. 6 wiedergegebenen Beispiel wird beim Übergang eines Binärwortes 01111111 (Zustand Ib) nach 10000000 wird (Zustand IIb) lediglich in Zeile Z16 und Spalte X8 eine Einzelquelle zugeschaltet, wobei die Änderung der Zustände am Zeilendekoder 2 nicht ausschlaggebend sind, für die Zuschaltung der Einzelquelle, $Q_{16,8}$, sondern diese vielmehr durch die Änderung von E8 und S8 aktiviert wird.

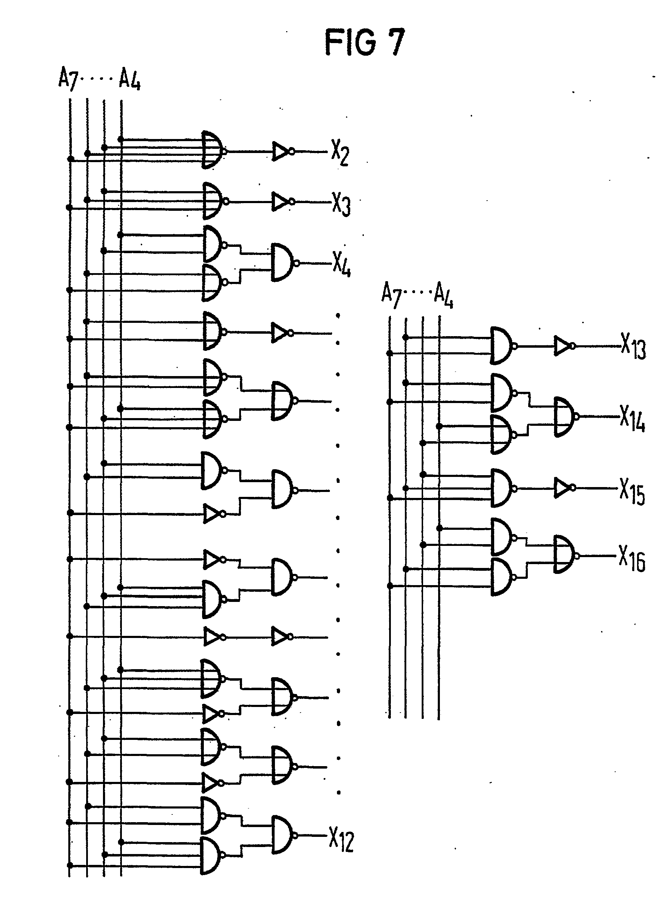

Fig. 7 zeigt die Schaltungsanordnung eines Thermometerdekoders zum Dekodieren eines vierstelligen Binärwortes, wie er als Spaltendekoder 3 verwendet ist. Es werden die vier höherwertigen Bits A4 bis A7 als Eingangsvariable zugeführt. Ausgangsseitig sind die Spalteninformationen X12 bis X16 abgreifbar. Um an jedem Ausgang Signale mit gleich langen internen Laufzeiten zu erhalten, sind in die Signalwege, die im Vergleich zu parallel geschalteten Signalwegen kein log. Verknüpfungsglied aufweisen, Inverter geschaltet. Auf diese Weise werden alle Einzelquellen gleichzeitig geschaltet.

## Patentansprüche

1. Einschrittiger D/A-Wandler mit einer Vielzahl von zusammenschaltbaren, von einer Dekoderanordnung angesteuerten Einzelquellen (6), wobei die Einzelquellen (6) matrixförmig angeordnet und zumindest der höherwertige Teil eines zu wandelnden, n-Bit breiten Digitalwortes (A0 bis An-1 von einem Spaltendekoder (3) unter Zwischenschaltung einer Logikanordnung (7, 12) angesteuert ist, in welcher die Matrixspalte der aktuell angesteuerten Einzelquelle (6) bestimmt und ein Umschalten der Einzelquellen (6) der übrigen Spalten unterdrückt wird, dadurch gekennzeichnet, daß mindestens der Spaltendekoder (3) als Thermometerdekoder ausgebildet ist, daß die Logikanordnung (7, 12) aus

a) einer dem Spaltendekoder (3) nachgeschalteten ersten Logikanordnung (12) zur Ableitung einer weiteren Spalteninformation ($E_i$) und einer zusätzlichen Information ($S_i$) aus der Spalteninformation ($X_i$) gemäß den logischen Verknüpfungen:

$E_i = \overline{X_i}$ und
$S_i = \overline{E_i \cdot E_{i-1}}$,

b) einer jeweils jeder Einzelquelle (6, $Q_{ik}$) zugeordneten zweiten Logikanordnung (7) gemäßfolgender logischen Verknüpfung mit einer Zeileninformation $Z_k$ besteht:

| $S_i$ | $Z_k$ | $Q_{ik}$ | |
|---|---|---|---|
| 0 | x | abgeschaltet | für die gesamte |
| 1 | x | zugeschaltet | Spalte $X_i$ |
| 1 | 0 | «ein» | |
| 1 | 1 | «aus» | |

und daß zwischen der Logikanordnung und der betreffenden Einzelquelle (6) eine Synchronisierschaltung (11) liegt, die zusammen mit allen anderen Synchronisierschaltungen an einer gemeinsamen Taktleitung (8) liegt.

2. D/A-Wandler nach Anspruch 1, dadurch gekennzeichnet, daß eine quadratische Matrix (1) und jeweils ein m-aus-$2^{n/2}$-Zeilen- und Spaltendekoder (2,3) verwendet sind.

3. D/A-Wandler nach einem der Ansprüche 1 oder 2, dadurch gekennzeichnet, daß die Matrix (1) zeilenmäßig direkt über den niederwertigen Teil des zu wandelnden Digitalwortes ($A_0$ bis $A_{n-1}$) angesteuert ist.

4. D/A-Wandler nach einem der vorhergehenden Ansprüche, dadurch gekennzeichnet, daß die Taktleitung (8) mäanderförmig nacheinander alle Spalten der Matrix (1) durchläuft.

5. D/A-Wandler nach Anspruch 4, dadurch gekennzeichnet, daß alle Einzelquellen (6) gemeinsam an einem Strombus (10) liegen.

6. D/A-Wandler nach Anspruch 4 oder 5, dadurch gekennzeichnet, daß alle Einzelquellen (6) gemeinsam an einer Versorgungsleitung (9) liegen.

7. D/A-Wandler nach einem der vorhergehenden Ansprüche, dadurch gekennzeichnet, daß in den Thermometerdekoder Inverter parallel zu log. Verknüpfungsgliedern geschaltet sind, um in parallelen Signalwegen einen Laufzeitausgleich herzustellen.

## Claims

1. Single-step D/A converter having a plurality of interconnectable individual sources (6) driven by a decoder arrangement, the individual sources (6) being arranged in the form of a matrix, and at least the high-order portion of an n-bit wide digital word ($A_0$

to $A_{n-1}$) to be converted being driven by a column decoder (3) with the interposition of a logic array (7, 12), in which the matrix column of the actually driven individual sources (6) is determined, and a changeover of the individual sources (6) of the remaining columns is suppressed, characterized in that at least the column decoder (3) is designed as thermometer decoder, in that the logic array (7, 12) consists of

a) a first logic array (12) downstream of the column decoder (3) for deriving a further column information item ($E_i$) and an additional information item ($S_i$) from the column information ($X_i$) in accordance with the logical combinations:

$E_i = \overline{X_i}$ and
$S_i = \overline{E_i \cdot E_{i-1}}$ and

b) a second logic array (7) assigned in each case to each individual source (6, $Q_{ik}$) in accordance with the following logical combination with a line information item $Z_k$:

| $S_i$ | $Z_k$ | $Q_{ik}$ | |
|---|---|---|---|
| 0 | x | disconnected | for the entire |
| 1 | x | connected | column $X_i$ |
| 1 | 0 | "on" | |
| 1 | 1 | "off" | |

and in that there is located between the logic array and the individual source (6) concerned a synchronizing circuit (11), which is connected together with all other synchronizing circuits to a common timing circuit (8).

2. A D/A converter according to Claim 1, characterized in that a quadratic matrix (1) and, in each case, an m-out-of-$2^{n/2}$ line and column decoder (2, 3) are used.

3. A D/A converter according to one of Claims 1 or 2, characterized in that the matrix (1) is driven linewise directly via the low-order portion of the digital word ($A_0$ to $A_{n-1}$) to be converted.

4. A D/A converter according to one of the preceding Claims, characterized in that the timing circuit (8) runs through all columns of the matrix (1) one after another in a meandering fashion.

5. A D/A converter according to Claim 4, characterized in that all individual sources (6) are jointly connected to a current bus (10).

6. A D/A converter according to Claim 4 or 5, characterized in that all individual sources (6) are jointly connected to a supply line (9).

7. A D/A converter according to one of the preceding claims, characterized in that converters are connected in parallel with the logical combinative elements in the thermometer decoder in order to produce equalization of propagation time in parallel signal paths.

## Revendications

1. Convertisseur numérique/analogique cyclique comportant une multiplicité de sources individuelles (6) pouvant être interconnectées, qui sont commandées par des dispositifs de décodage, les sources individuelles (6) étant disposées sous la forme d'une matrice et au moins la partie de poids supérieur d'un mot numérique devant être converti et possédant une largeur égale à n bits ($A_0$ à $A_{n-1}$) est commandée par un décodeur de colonnes (3), moyennant le montage intercalé d'un dispositif logique (7, 12), dans lequel la colonne de la matrice, qui contient la source individuelle (6) actuellement commandée, est déterminée et une commutation des sources individuelles (6) des autres colonnes est supprimée, caractérisé par le fait qu'au moins le décodeur de colonnes (3) est réalisé sous la forme d'un décodeur du type à diagramme à barres, que le dispositif logique (7, 12) est constitué par

a) un premier dispositif logique (12) branché en aval du décodeur de colonnes (3) et servant à délivrer une autre information de colonne ($E_i$) et une information supplémentaire ($S_i$) formée à partir de l'information de colonne ($X_i$) conformément aux combinaisons logiques:

$E_i = \overline{X_i}$ et

$S_i = E_i \cdot E_{i-1}$ et

b) un second dispositif logique (7) associé respectivement à chaque source individuelle (6, $Q_{ik}$), conformément à la combinaison logique suivante avec une information de ligne $Z_k$:

| $S_i$ | $Z_k$ | $Q_{ik}$ | |
|---|---|---|---|
| 0 | x | déconnectée | pour toute la colonne $X_i$ |
| 1 | x | connectée | |
| 1 | 0 | «branché» | |
| 1 | 1 | «débranchée» | |

et qu'entre le dispositif logique et la source individuelle considérée (6) se trouve disposé un circuit de synchronisation (11), qui est raccordé, conjointement avec tous les autres circuits de synchronisation, à un conducteur commun (8) de transmission de cadence.

2. Convertisseur numérique/analogique suivant la revendication 1, caractérisé par le fait qu'on utilise une matrice carrée (1) et respectivement un décodeur de lignes et un décodeur de colonnes m-parmi-$2^{n/2}$ (2, 3).

3. Convertisseur numérique/analogique suivant l'une des revendications 1 ou 2, caractérisé par le fait que la matrice (1) est commandée, suivant des lignes, directement par l'intermédiaire de la partie de poids le plus faible du mot numérique à convertir ($A_0$ à $A_{n-1}$).

4. Convertisseur numérique/analogique suivant l'une des revendications précédentes, caractérisé par le fait que le conducteur (8) de transmission de la cadence traverse successivement, avec une forme sinueuse, toutes les colonnes de la matrice (1).

5. Convertisseur numérique/analogique suivant la revendication 4, caractérisé par le fait que toutes les sources individuelles (6) sont raccordées en commun à un bus (10) d'alimentation en courant.

6. Convertisseur numérique/analogique suivant la revendication 4 ou 5, caractérisé par le fait que toutes les sources individuelles (6) sont raccordées en commun à un conducteur d'alimentation (9).

7. Convertisseur numérique/analogique suivant l'une des revendications précédentes, caractérisé par le fait que des inverseurs sont branchés, dans le décodeur du type à diagramme à barres, en parallèle avec des circuits combinatoires logiques, pour établir une compensation du temps de transit dans des voies parallèles de transmission de signaux.

EP 0 176 981 B1

**FIG 1**

| $E_i$ | $S_i$ | $Z_K$ | Stromquelle $Q_{ik}$ |
|---|---|---|---|
| 1 | 0 | X | abgeschaltet |
| 0 | 1 | X | zugeschaltet } für gesamte Spalte $X_i$ |
| 1 | 1 | 0 | "EIN" |
| 1 | 1 | 1 | "AUS" |

**FIG 4**

EP 0 176 981 B1

FIG 2

$$S_i = \overline{\overline{E_i} \cdot \overline{E_{i-1}}}$$
$$E_i = \overline{X_i}$$

FIG 3

# FIG 5

FIG 6

# FIG 7